# EUROPÄISCHE PATENTSCHRIFT

(11) **EP 3 564 503 B1**
(45) Veröffentlichungstag und Bekanntmachung des Hinweises auf die Patenterteilung: **09.12.2020**
(21) Anmeldenummer: 19167837.4
(22) Anmeldetag: 08.04.2019
(51) Int. Cl.: F01N 3/20, F01N 9/00

(54) **VERFAHREN ZUR TEMPERATURERMITTLUNG EINES ELEKTRISCH BEHEIZBAREN KATALYSATORS**
METHOD FOR TEMPERATURE DETERMINATION OF AN ELECTRICALLY HEATED CATALYST
PROCÉDÉ DE DÉTERMINATION DE LA TEMPÉRATURE D'UN CATALYSEUR CHAUFFÉ ÉLECTRIQUEMENT

(30) Priorität: 30.04.2018 DE 102018110382
(43) Veröffentlichungstag der Anmeldung: 06.11.2019
(73) Patentinhaber: VOLKSWAGEN AKTIENGESELLSCHAFT, 38440 Wolfsburg (DE)
(72) Erfinder: Naumann, Hardy, 38442 Wolfsburg (DE); Paukner, Stefan, 38442 Wolfsburg (DE)
(74) Vertreter: Gulde & Partner

(56) Entgegenhaltungen:
- DE-A1- 19 645 577
- DE-A1-102004 046 917
- DE-A1-102011 017 675
- DE-A1-102013 008 829
- DE-U1- 8 905 073
- JP-A- H 051 526
- Anonymous: "Abwärtswandler", Wikipedia, 14. September 2017 (2017-09-14), Seiten 1-5, XP055586655, Gefunden im Internet: URL:https://de.wikipedia.org/wiki/Abwärtsw andler [gefunden am 2019-05-08]
- Anonymous: "Vierleitermessung", wikipedia, 30. Januar 2018 (2018-01-30), Seiten 1-4, XP055586664, Gefunden im Internet: URL:https://de.wikipedia.org/wiki/Vierleit ermessung [gefunden am 2019-05-08]
- ERHARD OTTO ET AL: "DIE SYSTEMENTWICKLUNG DES ELEKTRISCH HEIZBAREN KATALYSATORS E-KAT FUR DIE LEV/ULEV- UND EU-III-GESETZGEBUNG.", MTZ - MOTORTECHNISCHE ZEITSCHRIFT, SPRINGER, Bd. 56, Nr. 9, 1. September 1995 (1995-09-01), Seite 488, XP000527161, ISSN: 0024-8525

## Beschreibung

Die Erfindung betrifft ein Verfahren zur Temperaturermittlung eines elektrisch beheizbaren Katalysators in einer Abgasanlage eines Verbrennungsmotors sowie eine Abgasanlage mit einem solchen elektrisch beheizbaren Katalysator.

Bei Verbrennungsmotoren erfolgt die Abgasnachbehandlung der Verbrennungsgase durch in der Abgasanlage des Verbrennungsmotors angeordnete Katalysatoren. Da diese Katalysatoren jedoch insbesondere nach einem Kaltstart des Verbrennungsmotors noch nicht ihre zur Konvertierung von Schadstoffen nötige Temperatur erreicht haben, ist die Konvertierung der Schadstoffe in dieser Kaltstartphase unzureichend. Aus dem Stand der Technik sind elektrisch beheizbare Katalysatoren bekannt, bei denen der Katalysator unabhängig vom Abgasstrom durch ein elektrisches Heizelement aufgeheizt werden kann. Somit kann der Zeitraum, in welchem der Katalysator nach einem Kaltstart noch nicht seine zur Konvertierung von Schadstoffen notwendige Temperatur erreicht hat, verkürzt werden. Somit können schädliche Abgaskomponenten nach einem Kaltstart schneller konvertiert und somit die Emissionen eines Kraftfahrzeuges verringert werden.

Der Betrieb eines elektrisch beheizbaren Katalysators erfordert ein Stellglied für die Stromzufuhr. Als Stellglied kann beispielsweise ein gesteuerter Stromrichter zum Einsatz kommen, welcher über Einrichtungen zur Strom- und Spannungsmessung verfügt.

Generell ist die Bauteiltemperatur der Katalysatoren in der Abgasanlage eines Kraftfahrzeuges von Interesse, um einerseits die Katalysatorfunktion zu überwachen und andererseits Temperaturgrenzen einzuhalten, ab welchen die Funktion des Katalysators eingeschränkt ist und/oder eine thermische Schädigung des Katalysators droht.

Grundsätzlich kann die Bauteiltemperatur eines Katalysators durch den Einsatz von Temperatursensoren in der Abgasanlage bestimmt werden. Dies führt allerdings zu einer entsprechenden Kostenerhöhung der Abgasanlage. Daher wird die Bauteiltemperatur in der Regel auf Basis von Modellen ermittelt, welche anhand einer gemessenen oder berechneten Abgastemperatur die Bauteiltemperatur der Katalysatoren in der Abgasanlage berechnen.

Durch den Einsatz eines elektrisch beheizbaren Katalysators ist es möglich, die Temperatur des Katalysators in der Kaltstartphase zu erhöhen und damit die Umsetzung von schädlichen Abgaskomponenten nach dem Kaltstart zu beschleunigen. Ein solcher elektrisch beheizbarer Katalysator kann sowohl in einer motornahen Position als auch in einer Unterbodenposition eines Kraftfahrzeuges angeordnet sein. Bei der Ermittlung der Bauteiltemperatur aus einem Berechnungsmodell ist aufgrund der Vielzahl von Umgebungseinflüssen mit Unsicherheiten zu rechnen, welche sich mit zunehmendem Abstand des Katalysators vom Auslass des Verbrennungsmotors vergrößern. Daher kann es sein, dass bei einem Katalysator in Unterbodenlage des Kraftfahrzeuges nur eine unzureichende Modellierung der Abgastemperatur möglich ist und die ermittelte Temperatur entsprechend stark von der tatsächlichen Bauteiltemperatur abweicht.

Aus dem Stand der Technik ist bekannt, bei einem elektrisch beheizbaren Katalysator anhand des Widerstandes des elektrischen Heizelements die Bauteiltemperatur zu ermitteln. Da der Heizwiderstand eines elektrisch beheizbaren Katalysators in der Regel eine hohe Abhängigkeit von der Bauteiltemperatur hat und sich mit zunehmender Bauteiltemperatur bei gleicher Stromstärke erhöht, kann aus dem Heizwiderstand bei bekannter Spannung und bekannter Stromstärke die Bauteiltemperatur des elektrisch beheizbaren Katalysators abgeleitet werden.

Aus der DE 8 905 073 U1 ist ein Verfahren zur Ermittlung der Bauteiltemperatur eines elektrisch beheizbaren Katalysators bekannt, welcher aus elektrisch leitenden Schalen aufgebaut ist, wobei die Temperatur durch eine temperaturbedingte Änderung des Widerstandes ermittelt wird.

Aus der DE 10 2004 046 917 ist bekannt, bei einem elektrisch beheizbaren Katalysator die Temperatur des Katalysators über die Änderung des Widerstandes des elektrischen Heizdrahtes zu ermitteln, wobei das elektrische Beheizen des Katalysators abgeschaltet wird, sobald die auf diese Weise ermittelte Bauteiltemperatur über einer Aktivierungstemperatur (Light-Off-Temperatur) des Katalysators liegt und dieser anschließend dann chemisch durch die katalytische Reaktion weiter aufgeheizt wird.

Die DE 10 2011 017 675 A1 offenbart ein Verfahren, bei dem die Ermittlung der Temperaturkennlinie eines elektrisch beheizbaren Katalysators aus der temperaturbedingten Veränderung des elektrischen Widerstands eines Heizelements des elektrisch beheizbaren Katalysators erfolgt.

Die DE 10 2013 008 829 A1 offenbart ein Kraftfahrzeug mit einer Batterie, welche einen ersten Pol und einen zweiten Pol aufweist, sowie mit mindestens einem Kondensator und mindestens einem Verbraucher. Dabei sind ein DC/DC Wandler und eine Steuervorrichtung vorgesehen, wobei der Verbraucher zwischen den ersten Pol der Batterie und ein Erdpotenzial geschaltet ist. Somit fällt an dem Verbraucher eine Betriebsspannung ab, wobei ein Referenzpotential eines Eingangs und eines Ausgangs des DC/DC Wandlers das Erdpotenzial ist.

Aus der DE 196 45 577 A1 ist eine Abgasreinigungsvorrichtung für einen Verbrennungsmotor bekannt, welche in der Lage ist, einen Katalysator unter Berücksichtigung einer Verschlechterung im Verlauf der Zeit und von Fertigungstoleranzen bei einer elektrischen Heizeinrichtung zur Aufheizung des Katalysators in befriedigender Weise aufzuheizen.

Die JP 05 001 526 A offenbart einen elektrisch beheizbaren Katalysator sowie eine Steuerungseinrichtung zur Ansteuerung eines elektrischen Heizelements des elektrisch beheizbaren Katalysators.

Aufgabe der Erfindung ist es, die Ermittlung der Bauteiltemperatur eines elektrisch beheizbaren Katalysators anhand der temperaturbedingten Veränderung des Heizwiderstandes weiter zu verbessern.

Erfindungsgemäß wird die Aufgabe durch ein Verfahren zur Temperaturermittlung eines elektrisch beheizbaren Katalysators in einer Abgasanlage eines Verbrennungsmotors gelöst. Dabei weist der elektrisch beheizbare Katalysator einen Heizwiderstand mit einem temperaturabhängigen Widerstand auf, wobei die Bauteiltemperatur des elektrisch beheizbaren Katalysators aus dem temperaturabhängigen elektrischen Widerstand des Heizwiderstands ermittelt wird. Es ist vorgesehen, dass die Bestromung des elektrischen Heizwiderstands durch ein Schließen eines Schalters in einem Stromkreis erfolgt, welcher eine Batterie eines Kraftfahrzeuges mit dem elektrischen Heizwiderstand verbindet, wobei die Bauteiltemperatur bei bekannter Stromstärke und bekannter Spannung aus dem elektrischen Widerstand ermittelt wird. Durch ein erfindungsgemäßes Verfahren ist eine Ermittlung der mittleren Bauteiltemperatur des elektrisch beheizbaren Abgaskatalysators, insbesondere eines elektrisch beheizbaren Drei-Wege-Katalysators oder eines elektrisch beheizbaren Vier-Wege-Katalysators, ohne einen zusätzlichen Temperatursensor möglich. Dabei ist der Heizwiderstand vorzugsweise als Heizscheibe ausgebildet, welche mechanisch mit dem Katalysatorkörper des elektrisch beheizbaren Katalysators verbunden ist, um die elektrischen Energie effizient in den Katalysatorkörper einbringen zu können. Die Bauteiltemperatur des elektrisch beheizbaren Katalysators wird dabei auf Basis eines Messwertes ermittelt und ist somit vergleichsweise gering störungsanfällig gegenüber Umwelteinflüssen, welche in einer modellbasierten Bestimmung der Temperatur nicht oder nur unzureichend berücksichtigt werden können. Durch einen schaltbaren Stromkreis ist eine besonders einfache Ansteuerung des elektrischen Heizwiderstandes möglich, sodass der Heizwiderstand jeweils nur kurzzeitig bestromt und somit erhitzt wird, wodurch die Energieeffizienz und die Dauerhaltbarkeit des Heizwiderstands und des elektrisch beheizbaren Katalysators erhöht werden können.

Durch die in den abhängigen Ansprüchen aufgeführten Merkmale sind vorteilhafte Verbesserungen und Weiterentwicklungen des im unabhängigen Anspruch angegebenen Verfahrens zur Temperaturermittlung der Bauteiltemperatur eines elektrisch beheizbaren Katalysators möglich.

In bevorzugter Ausgestaltung der Erfindung ist vorgesehen, dass die Bauteiltemperatur des elektrisch beheizbaren Katalysators in einer Betriebsphase ermittelt wird, in welcher ein elektrisches Beheizen des elektrisch beheizbaren Katalysators nicht vorgesehen ist. Durch eine kurzzeitige Ansteuerung des elektrischen Heizwiderstands wird nur eine geringe Energiemenge in den elektrisch beheizbaren Katalysator eingebracht, sodass sich die Temperatur des elektrisch beheizbaren Katalysators während der Messung nur unwesentlich ändern und näherungsweise als konstant angesehen werden kann. Somit kann insbesondere in Betriebszuständen, in denen kein elektrisches Beheizen des Katalysators vorgesehen ist, eine vergleichsweise genaue Ermittlung der Bauteiltemperatur des elektrisch beheizbaren Katalysators erfolgen.

Bevorzugt ist dabei, wenn die Bestromungsdauer für die Widerstandsmessung in einer solchen Phase zwischen 50 µs und 200 µs gewählt wird. Die Messphase ist entsprechend kurz zu gestalten, um den Energieeintrag in den Heizwiderstand gering zu halten. Dadurch werden eine Überhitzung des Heizelements sowie ein zu hoher Stromverbrauch vermieden. Eine noch kürzere Ansteuerdauer könnte zu Messfehlern führen, da das Messsystem bei kürzerer Messdauer noch nicht seinen eingeschwungenen Zustand erreicht hat. Längere Messphasen führen zu einem unnötig hohen Energieeintrag und einer daraus resultierenden erhöhten Alterung des Heizwiderstandes.

In einer vorteilhaften Ausführungsform des Verfahrens ist vorgesehen, dass ein Korrekturfaktor ermittelt wird, welcher eine Veränderung des elektrischen Widerstands des Heizwiderstands durch eine Alterung des elektrisch beheizbaren Katalysators berücksichtigt. Durch einen Korrekturfaktur kann eine betriebsbedingte Alterung des elektrischen Widerstands des Heizwiderstands kompensiert und somit die Messgenauigkeit der Bauteiltemperatur über die Lebensdauer des elektrisch beheizbaren Katalysators verbessert werden.

Erfindungsgemäß ist vorgesehen, dass der Leistungseintrag in den Messstromkreis mittels eines Pulsweitenmodulation gesteuerten Abwärtswandlers erfolgt. Mithilfe eines Pulsweitenmodulation gesteuerten Abwärtswandlers, insbesondere einem Abwärtswandler mit MOSFET Schaltern, besonders bevorzugt mit einer mehrphasig ausgeführten MOSFET Schaltung, lässt sich jeder beliebige Leistungseintrag zwischen Null und Maximalleistung darstellen. Dabei ist der Leistungseintrag durch die Batteriespannung und den elektrischen Widerstand des Heizwiderstands begrenzt.

Erfindungsgemäß ist dabei vorgesehen, dass die Messung von elektrischer Stromstärke und Spannung mindestens zehnmal innerhalb einer Pulsweitenmodulation-Periode erfolgt. Die Regelung des elektrischen Stroms erfordert auch dessen Messung. Diese Messung von elektrischer Stromstärke I und Spannung U sollte mindestens zehnmal innerhalb einer Pulsweitenmodulation-Periode erfolgen, um eine gute Mittelwertbildung zu ermöglichen. Auch in Phasen, in denen der elektrisch beheizbare Katalysator nicht beheizt wird, kann der elektrische Widerstand des Heizwiderstandes ermittelt und daraus die Bauteiltemperatur berechnet werden. Dies erfolgt entweder durch einmaliges Einschalten des Schalters im Stromkreis oder mehrmaliges Takten bei kleinem Pulsweitenmodulationsverhältnis, bis das System eingeschwungen ist. Bei einem einmaligen Einschalten sollte die Dauer der Bestromung mindestens das Fünffache der elektrischen Systemzeitkonstante betragen, welche sich näherungsweise aus einer Reihenschaltung des Heizwiderstands und einer Induktivität L ergibt.

Besonders bevorzugt ist dabei, dass eine Temperaturregelung für den elektrisch beheizbaren Katalysator den Abwärtswandler als kontinuierlichen Stromsteller nutzt. Dabei ist eine kontinuierliche Messung von der Stromstärke und der Spannung vorgesehen.

In einer weiteren Verbesserung des Verfahrens ist vorgesehen, dass bei der Berechnung der Temperatur zusätzlich zum elektrischen Widerstand des Heizwiderstandes der Leitungswiderstand des elektrischen Leiters berücksichtigt wird. Im einfachsten Fall wird der Leitungswiderstand als konstant angesehen und vom gemessenen Widerstand des Heizwiderstands abgezogen.

In weiterer bevorzugter Ausgestaltung der Erfindung ist vorgesehen, dass die Widerstandsmessung mittels einer Vierdraht-Messmethode erfolgt. Soll die Messgenauigkeit bei der Bestimmung des elektrischen Widerstands des Heizwiderstands weiter erhöht werden, bietet sich eine sogenannte Vierdraht-Messmethode an. Das Mess- und Ansteuerverfahren wird dadurch nicht grundsätzlich verändert, jedoch kann die Messgenauigkeit verbessert werden.

Erfindungsgemäß wird ein Abgasnachbehandlungssystem für einen Verbrennungsmotor mit einer Abgasanlage vorgeschlagen, in welcher ein elektrisch beheizbarer Katalysator, insbesondere ein elektrisch beheizbarer Drei-Wege-Katalysator oder ein elektrisch beheizbarer Vier-Wege-Katalysator, angeordnet ist. Das Abgasnachbehandlungssystem umfasst ein Steuergerät, insbesondere ein Motorsteuergerät des Verbrennungsmotors, welches dazu eingerichtet ist, ein erfindungsgemäßes Verfahren durchzuführen, wenn ein maschinenlesbarer Programmcode durch das Steuergerät ausgeführt wird. In einem erfindungsgemäßen Abgasnachbehandlungssystem ist es möglich, die Bauteiltemperatur des elektrisch beheizbaren Katalysators vergleichsweise energiesparend und genau zu ermitteln, sodass der Katalysator mit hoher Effizienz betrieben werden kann. Somit kann die Konvertierungsleistung des Katalysators erhöht und/oder das Alterungsverhalten des Katalysators verbessert werden.

Weitere bevorzugte Ausgestaltungen der Erfindung ergeben sich aus den übrigen, in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in Ausführungsbeispielen anhand der zugehörigen Zeichnungen erläutert. Es zeigen:
- Figur 1: einen Verbrennungsmotor mit einer Abgasanlage, in der ein elektrisch beheizbarer Katalysator zur Abgasnachbehandlung der Verbrennungsgase des Verbrennungsmotors angeordnet ist;
- Figur 2: einen elektrischen Schaltkreis zur Ansteuerung eines elektrischen Heizwiderstands zum elektrischen Beheizen eines Katalysators;
- Figur 3: einen weiteren elektrischen Schaltkreis zur Ansteuerung eines elektrischen Heizwiderstands eines elektrisch beheizbaren Katalysators
- Figur 4: eine Regleranordnung zur Temperatur- und Stromregelung für den elektrischen Heizwiderstand des elektrisch beheizbaren Katalysators, und
- Figur 5: einen weiteren elektrischen Schaltkreis zur Ansteuerung eines elektrischen Heizwiderstands eines elektrisch beheizbaren Katalysators.

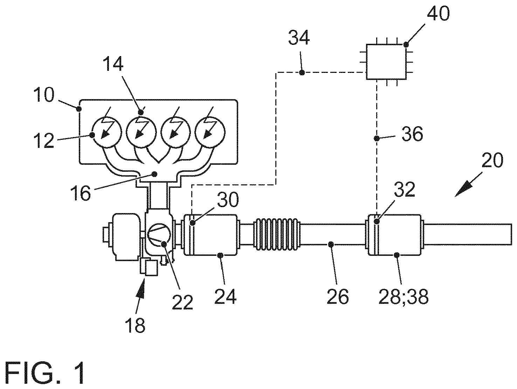

Figur 1 zeigt einen Verbrennungsmotor 10, welcher mit seinem Auslass 16 mit einer Abgasanlage 20 verbunden ist. Der Verbrennungsmotor 10 ist vorzugsweise als fremdgezündeter Verbrennungsmotor 10 nach dem Ottoprinzip ausgeführt und weist eine Mehrzahl von Brennräumen 12 auf, an welche jeweils mindestens eine Zündkerze 14 zur Zündung eines zündfähigen Kraftstoff-Luft-Gemischs angeordnet ist. Alternativ kann der Verbrennungsmotor 10 auch als selbstzündender Verbrennungsmotor nach dem Dieselprinzip ausgeführt sein. Der Verbrennungsmotor 10 ist vorzugsweise als mittels eines Abgasturboladers 18 aufgeladenen Verbrennungsmotor 10 ausgeführt. Alternativ kann der Verbrennungsmotor 10 auch als nicht aufgeladener Saugmotor oder als mittels eines Kompressors oder elektrischen Verdichters aufgeladener Verbrennungsmotor 10 ausgeführt sein. Die Abgasanlage 20 umfasst einen Abgaskanal 26, wobei in Strömungsrichtung eines Abgases durch die Abgasanlage 20 eine motornahe Turbine 22 des Abgasturboladers, stromabwärts der Turbine 22 ein motornaher Katalysator 24 und weiter stromabwärts, vorzugsweise in Unterbodenlage eines Kraftfahrzeuges, ein zweiter Katalysator 28 angeordnet sind. Zumindest einer der Katalysatoren ist als elektrisch beheizbarer Katalysator 24, 28, vorzugsweise als elektrisch beheizbarer Drei-Wege-Katalysator oder als elektrisch beheizbarer Vier-Wege-Katalysator 38 ausgeführt. Alternativ kann der elektrisch beheizbare Katalysator 24, 28 auch als SCR-Katalysator oder als sonstige Abgasnachbehandlungskomponente ausgeführt sein. Mindestens einer der Katalysatoren 24, 28, 38 weist ein elektrisches Heizelement 30, 32, insbesondere eine Heizscheibe auf, mit welcher der Katalysator 24, 28, 38 unabhängig vom Abgasstrom des Verbrennungsmotors 10 beheizt werden kann. Dazu sind die elektrischen Heizelemente 30, 32 jeweils über Signalleitungen 34, 36 mit einem Steuergerät 40 des Verbrennungsmotors 10 verbunden

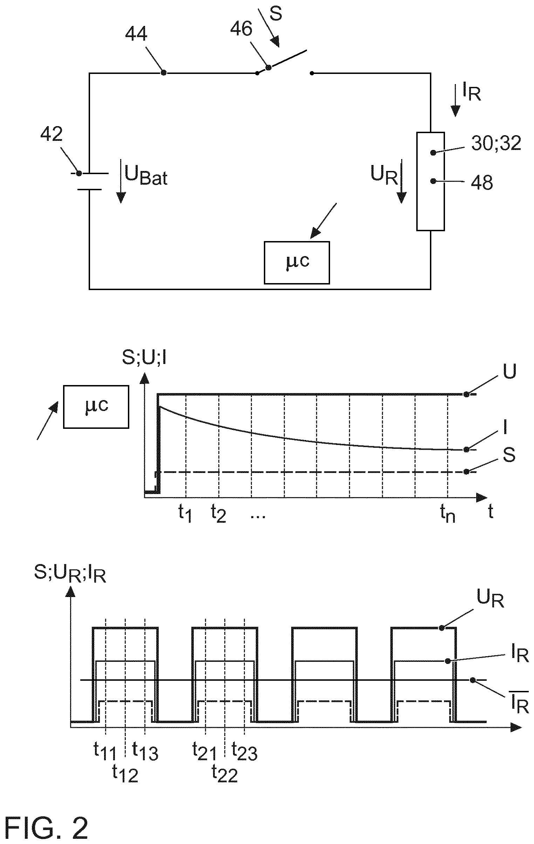

In Figur 2 ist ein elektrischer Schaltkreis für das elektrische Heizelement 30, 32, insbesondere für einen Heizwiderstand 48 dargestellt. Dabei umfasst der Schaltkreis einen Stromkreis 44, welcher eine Batterie 42 des Kraftfahrzeuges mit dem elektrischen Heizwiderstand 48 verbindet. Der elektrische Heizwiderstand 48 ist vorzugsweise als Metallfilm oder Metalldraht in das Trägermaterial des elektrisch beheizbaren Katalysators 24, 28, 38 integriert. Ferner weist der Schaltkreis einen Schalter 46 auf, mit welchem auf einfache Art und Weise die Stromzufuhr zu dem Heizwiderstand 48 unterbrochen beziehungsweise aktiviert werden kann. Die Batterie 42 kann beispielsweise eine 12 Volt Batterie oder eine 48 Volt Batterie eines Kraftfahrzeugs mit Verbrennungsmotor sein. Alternativ kann die Batterie 42 bei einem Hybridfahrzeug auch die Hochvoltbatterie für den elektrischen Antriebsmotor sein. Die Spannung U_{R} am Heizwiderstand 48 wird vorzugsweise durch einen Mikrocontroller µ_{C} abgetastet. Die Stromstärke I_{R} wird vorzugsweise durch Shunts oder durch einen Stromwandler in Verbindung mit einem Mikrocontroller µ_{C} gemessen. Der Schalter 46 ist beispielsweise als Relais oder als MOSFET ausgebildet. Der Heizwiderstand R ergibt sich aus der Spannung U_{R} und der Stromstärke I_{R} durch die Beziehung R = U_{R} / I_{R}. Die Bauteiltemperatur des elektrisch beheizbaren Katalysators 24, 28, 38 ist dann eine Funktion des Widerstands R, welcher sich in Abhängigkeit von der Temperatur des Katalysators 24, 28, 38 ändert. Das Bestromen des elektrischen Heizwiderstands 48 kann im einfachsten Fall durch zeitweises Einschalten des Stromkreises 44 erfolgen. Ist die gewünschte Bauteiltemperatur des elektrisch beheizbaren Katalysators 24, 28, 38 erreicht oder eine gewisse Zeitspanne verstrichen, wird der Stromkreis 44 durch Öffnen des Schalters 46 wieder geöffnet. Auch während Betriebsphasen, in denen der Katalysator 24, 28, 38 nicht beheizt werden soll, kann durch kurzzeitiges Bestromen des elektrischen Heizwiderstands 48 eine Widerstandsmessung erfolgen. Die Messphasen sind entsprechend kurz zu gestalten, um den Energieeintrag in den Heizwiderstand 48 möglichst gering zu halten. Dadurch wird eine Überhitzung des Heizwiderstands 48 sowie ein zu hoher Stromverbrauch vermieden.

Durch das vorgeschlagene Verfahren wird eine mittlere Bauteiltemperatur bestimmt. Die mittlere Bauteiltemperatur hat eine messtechnische Basis und ist damit robust gegenüber Umwelteinflüssen, welche in einer Ermittlung der Bauteiltemperatur über eine Modellberechnung nicht berücksichtigt werden können. Alterungseffekte des elektrischen Heizwiderstands 48 können adaptiert werden, wenn der Widerstand bei entsprechend gealterten Bauteilen und bekannter Umgebungstemperatur bestimmt wird.

Ein getaktetes Öffnen und Schließen des Schalters 46 führt zu einer getakteten Spannung U und einer getakteten Stromstärke I, die sich als mittlere Spannung beziehungsweise mittlere Stromstärke interpretieren lassen. Die Taktung kann ähnlich einer Pulsweitenmodulations-Taktung wie beim Abwärtswandler erfolgen oder mit geringerer Taktfrequenz. Typischerweise erfolgt eine solche Messung während der Einschaltphase des elektrisch beheizbaren Katalysators 24, 28, 38 nach dem Kaltstart des Verbrennungsmotors 10.

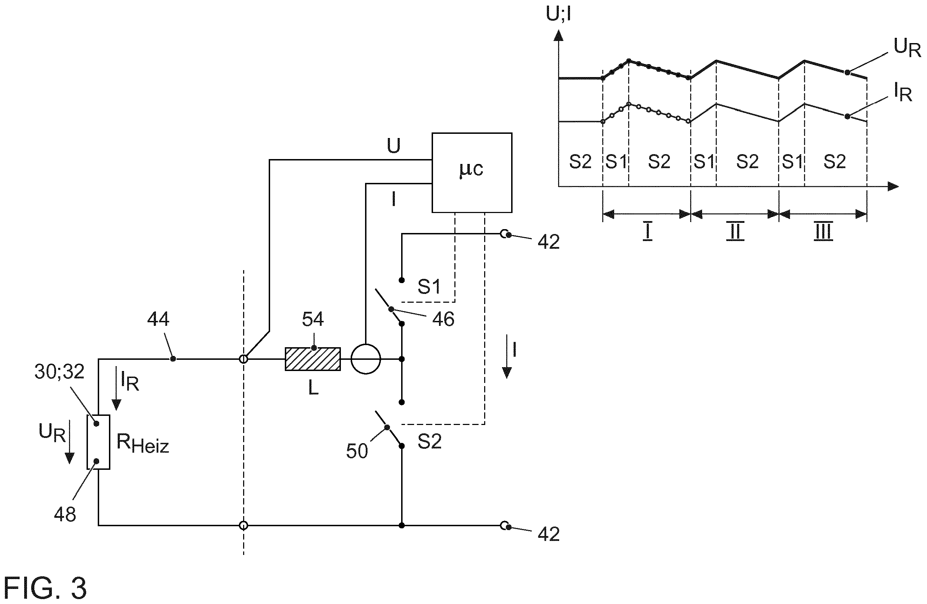

In Figur 3 ist ein bevorzugtes Ausführungsbeispiel für den elektrischen Stromkreis 44 zum Beheizen des elektrisch beheizbaren Katalysators 24, 28, 38 dargestellt. Mithilfe eines Pulsweitenmodulation gesteuerten Abwärtswandlers, welcher vorzugsweise mit MOSFET-Schaltern 46, 50 ausgeführt ist, lässt sich jeder beliebige Leistungseintrag zwischen Null und Maximalleistung darstellen. Der Stromkreis 44 umfasst gegenüber dem in Figur 2 dargestellten Ausführungsbeispiel zusätzlich einen zweiten Schalter 50 und eine Induktivität, insbesondere eine Spule 54. Die Regelung des Stroms erfordert auch dessen Messung. Die Messung der Stromstärke I_{R} und der Spannung U_{R} sollte mindestens zehnmal innerhalb einer Pulsweitenmodulations-Periode erfolgen, um eine gute Mittelwertbildung zu ermöglichen. Die Ermittlung der Bauteiltemperatur des elektrisch beheizbaren Katalysators über den temperaturabhängigen elektrischen Widerstand R des Heizwiderstands 48 kann beispielsweise durch einmaliges Einschalten des Schalters 46 mit einer Dauer von mindestens dem Fünffachen der elektrischen Systemzeitkonstante oder durch getaktetes, mehrmaliges Schalten bei kleinem Pulsweitenmodulationsverhältnis erfolgen.

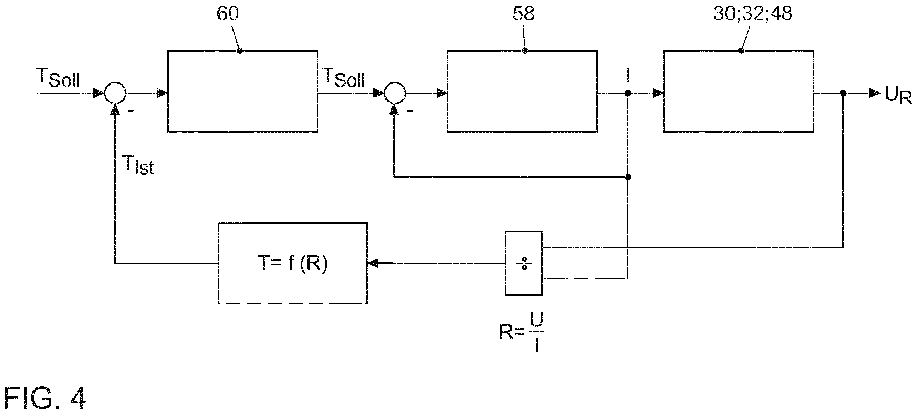

In Figur 4 ist eine Weiterentwicklung der in Figur 3 dargestellten Messanordnung gezeigt. Dabei erfolgt eine Temperaturregelung 60 für den elektrisch beheizbaren Katalysator 24, 28, 38, wobei der in Figur 3 dargestellte Abwärtswandler als kontinuierlicher Stromregler 58 genutzt wird.

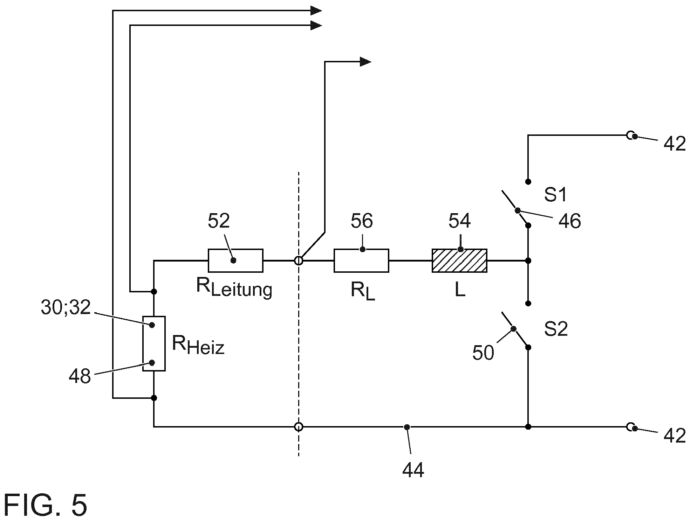

In Figur 5 ist ein weiteres Ausführungsbeispiel für einen Stromkreis 44 zum Beheizen des elektrisch beheizbaren Katalysators 24, 28, 38 dargestellt. Da im realen Betrieb neben dem elektrischen Widerstand R des Heizwiderstands 48 auch die Leitungen einen elektrischen Widerstand 52, 56 aufweisen, können auch diese Widerstände 52, 56 berücksichtigt werden. Die Leitungs- und Übergangswiderstände können im Rahmen der Berechnung des elektrischen Widerstands R des Heizwiderstands 48 in geeigneter Form kompensiert werden. In der einfachsten Form werden die Leitungswiderstände als konstant angenommen und vom gemessenen Widerstand R abgezogen. Soll die Messgenauigkeit bei der Bestimmung des elektrischen Widerstands R des elektrisch beheizbaren Katalysators 24, 28, 38 weiter erhöht werden, bietet sich eine sogenannte Vierdraht-Messung an, welche in Figur 5 dargestellt ist. Das Mess- und Ansteuerverfahren wird dadurch grundsätzlich nicht verändert, jedoch erhöht sich die zu erwartende Messgenauigkeit bei der Widerstandsmessung. Dadurch kann auch die Abweichung bei der Temperaturbestimmung der Bauteiltemperatur des elektrisch beheizbaren Katalysators 24, 28, 38 weiter verringert werden.

### Bezugszeichenliste

- 10: Verbrennungsmotor
- 12: Brennraum
- 14: Zündkerze
- 16: Auslass
- 18: Abgasturbolader

- 20: Abgasanlage
- 22: Turbine
- 24: motornaher Katalysator
- 26: Abgaskanal
- 28: zweiter Katalysator

- 30: erstes Heizelement
- 32: zweites Heizelement
- 34: Signalleitung
- 36: Signalleitung
- 38: Vier-Wege-Katalysator

- 40: Steuergerät
- 42: Batterie
- 44: Stromkreis
- 46: erster Schalter
- 48: Heizwiderstand

- 50: zweiter Schalter
- 52: Leitungswiderstand
- 54: Spule
- 56: zweiter Leitungswiderstand
- 58: Stromregler

- 60: Temperaturregler
- I: Stromstärke
- L: Spule
- R: Widerstand
- S: Schalter
- U: Spannung

- t: Zeit

## Patentansprüche

1. Verfahren zur Temperaturermittlung eines elektrisch beheizbaren Katalysators (24, 28) in einer Abgasanlage (20) eines Verbrennungsmotors (10), wobei der elektrisch beheizbare Katalysator (24, 28) einen Heizwiderstand (48) mit einem temperaturabhängigen Widerstand aufweist, und wobei die Bauteiltemperatur des elektrisch beheizbaren Katalysators (24, 28) aus dem temperaturabhängigen Widerstand des Heizwiderstands (48) ermittelt wird, wobei die Bestromung des elektrischen Heizwiderstands (48) durch ein Schließen eines Schalters (46, 50) in einem Stromkreis (44) erfolgt, welcher eine Batterie (42) mit dem elektrischen Heizwiderstand (48) verbindet, wobei die Bauteiltemperatur bei bekannter Stromstärke (I) und bekannter Spannung (U) aus dem elektrischen Widerstand (R) ermittelt wird, **dadurch gekennzeichnet, dass** der Leistungseintrag in den Messstromkreis mittels eines Pulsweitenmodulation-gesteuerten Abwärtswandlers erfolgt, wobei die Messung von Stromstärke (I) und Spannung (U) mindestens zehnmal innerhalb einer Pulsweitenmodulations-Periode erfolgt.

2. Verfahren nach Anspruch 1, **dadurch gekennzeichnet, dass** die Bauteiltemperatur des elektrisch beheizbaren Katalysators (24, 28) in einer Betriebsphase ermittelt wird, in der elektrisches Beheizen nicht vorgesehen ist.

3. Verfahren nach Anspruch 2, **dadurch gekennzeichnet, dass** die Bestromungsdauer für die Widerstandsmessung zwischen 50 und 200 µs gewählt wird.

4. Verfahren nach einem der Ansprüche 1 bis 3, **dadurch gekennzeichnet, dass** ein Korrekturfaktor ermittelt wird, welcher eine Veränderung des elektrischen Widerstands (R) des Heizwiderstands (48) durch eine Alterung des elektrisch beheizbaren Katalysators (24, 28) berücksichtigt.

5. Verfahren nach einem der Ansprüche 1 bis 4, **dadurch gekennzeichnet, dass** eine Temperaturregelung für den elektrisch beheizbaren Katalysator (24, 28) den Abwärtswandler als kontinuierlichen Stromsteller nutzt.

6. Verfahren nach einem der Ansprüche 1 bis 5, **dadurch gekennzeichnet, dass** bei der Berechnung der Temperatur zusätzlich zu dem elektrischen Widerstand (R) des Heizwiderstands (48) der Leitungswiderstand (52, 56) des elektrischen Leiters berücksichtigt wird.

7. Verfahren nach einem der Ansprüche 1 bis 6, **dadurch gekennzeichnet, dass** die Widerstandsmessung mittels einer Vierdraht-Messmethode erfolgt.

8. Abgasnachbehandlungssystem für einen Verbrennungsmotor (10) mit einer Abgasanlage (20), in welcher ein elektrisch beheizbaren Katalysator (24, 28) angeordnet ist, sowie mit einem Steuergerät (40), welches dazu eingerichtet ist, ein Verfahren nach einem der Ansprüche 1 bis 7 durchzuführen, wenn ein maschinenlesbarer Programmcode durch das Steuergerät (40) ausgeführt wird.

## Claims

1. Method for determining the temperature of an electrically heatable catalytic converter (24, 28) in an exhaust system (20) of an internal combustion engine (10), wherein the electrically heatable catalytic converter (24, 28) has a heating resistor (48) with a temperature-dependent resistance, and wherein the component temperature of the electrically heatable catalytic converter (24, 28) is determined from the temperature-dependent resistance of the heating resistor (48), wherein the energization of the electric heating resistor (48) is carried out by closing a switch (46, 50) in a circuit (44) which connects a battery (42) to the electric heating resistor (48), wherein the component temperature is determined from the electrical resistance (R) at a known current strength (I) and known voltage (U), **characterized in that** the input of power into the measuring circuit is carried out by means of a pulse-width-modulation-controlled down converter, wherein the measurement of the current strength (I) and voltage (U) is carried out at least ten times within a pulse-width-modulation period.

2. Method according to Claim 1, **characterized in that** the component temperature of the electrically heatable catalytic converter (24, 28) is determined in an operating phase in which electrical heating is not scheduled.

3. Method according to Claim 2, **characterized in that** the energization duration for the resistance measurement is selected between 50 and 200 µs.

4. Method according to one of Claims 1 to 3, **characterized in that** a correction factor is determined which takes into account a change in the electrical resistance (R) of the heating resistor (48) as a result of ageing of the electrically heatable catalytic converter (24, 28).

5. Method according to one of Claims 1 to 4, **characterized in that** a temperature regulation process for the electrically heatable catalytic converter (24, 28) makes use of the down converter as a continuous power controller.

6. Method according to one of Claims 1 to 5, **characterized in that**, for the calculation of the temperature, the line resistance (52, 56) of the electric lead is taken into account in addition to the electrical resistance (R) of the heating resistor (48).

7. Method according to one of Claims 1 to 6, **characterized in that** the resistance measurement is carried out by means of a four-wire measuring method.

8. Exhaust gas aftertreatment system for an internal combustion engine (10) having an exhaust system (20) in which an electrically heatable catalytic converter (24, 28) is arranged, and having a control unit (40) which is configured to carry out a method according to one of Claims 1 to 7 when a machine-readable program code is executed by the control unit (40) .

## Revendications

1. Procédé de détermination de la température d'un catalyseur (24, 28) pouvant être chauffé électriquement dans un système d'échappement (20) d'un moteur à combustion interne (10), dans lequel le catalyseur pouvant être chauffé électriquement (24, 28) comporte une résistance de chauffage (48) dont la résistance dépend de la température, et dans lequel la température de composant du catalyseur pouvant être chauffé électriquement (24, 28) est déterminée à partir de la résistance dépendant de la température de la résistance de chauffage (48), dans lequel l'alimentation en courant de la résistance électrique de chauffage (48) est effectuée par fermeture d'un commutateur (46, 50) dans un circuit (44) qui relie une batterie (42) à la résistance électrique de chauffage (48), dans lequel la température de composant est déterminée à partir de la résistance électrique (R) pour une intensité de courant (I) connue et une tension (U) connue, **caractérisé en ce que** l'apport de puissance dans le circuit de mesure est effectué au moyen d'un convertisseur abaisseur commandé par modulation de largeur d'impulsion, dans lequel la mesure de l'intensité de courant (I) et de la tension (U) est effectuée au moins dix fois au cours d'une période de modulation de largeur d'impulsion.

2. Procédé selon la revendication 1, **caractérisé en ce que** la température de composant du catalyseur (24, 28) pouvant être chauffé électriquement est déterminée au cours d'une phase de fonctionnement lors de laquelle le chauffage électrique n'est pas prévu.

3. Procédé selon la revendication 2, **caractérisé en ce que** la période de l'alimentation en courant servant à la mesure de la résistance est sélectionnée entre 50 et 200 µs.

4. Procédé selon l'une des revendications 1 à 3, **caractérisé en ce que** l'on détermine un facteur de correction qui tient compte d'une modification de la résistance électrique (R) de la résistance de chauffage (48) due à un vieillissement du catalyseur (24, 28) pouvant être chauffé électriquement.

5. Procédé selon l'une des revendications 1 à 4, **caractérisé en ce qu'**une régulation de la température du catalyseur (24, 28) pouvant être chauffé électriquement utilise le convertisseur abaisseur en tant que régulateur continu du courant.

6. Procédé selon l'une des revendications 1 à 5, **caractérisé en ce qu'**outre la résistance électrique (R) de la résistance de chauffage (48), la résistance de ligne (52, 56) du conducteur électrique est prise en compte lors du calcul de la température.

7. Procédé selon l'une des revendications 1 à 6, **caractérisé en ce que** la mesure de la résistance est effectuée au moyen d'une méthode de mesure à quatre fils.

8. Système de post-traitement des gaz d'échappement pour un moteur à combustion interne (10) comprenant un système d'échappement (20) dans lequel est disposé un catalyseur (24, 28) pouvant être chauffé électriquement, et comprenant un appareil de commande (40) qui est conçu pour mettre en œuvre un procédé selon l'une des revendications 1 à 7 lorsqu'un code de programme lisible par machine est exécuté par l'appareil de commande (40).
